# EUROPÄISCHE PATENTSCHRIFT

(11) **EP 2 861 461 B1**
(45) Veröffentlichungstag und Bekanntmachung des Hinweises auf die Patenterteilung: **12.07.2017**
(21) Anmeldenummer: 13729938.4
(22) Anmeldetag: 12.06.2013
(51) Int. Cl.: B60Q 1/14, B60Q 9/00

(54) **MANUELL BEDIENBARE SCHALTVORRICHTUNG FÜR EIN FAHRZEUG MIT SENSORAKTIVIERUNGSEINRICHTUNG**
MANUALLY OPERABLE SWITCH DEVICE FOR A VEHICLE, COMPRISING A SENSOR ACTIVATION SYSTEM
DISPOSITIF DE COMMUTATION À ACTIONNEMENT MANUEL POURVU D'UN DISPOSITIF D'ACTIVATION DE CAPTEUR, POUR UN VÉHICULE À MOTEUR

(30) Priorität: 13.06.2012 DE 102012011875
(43) Veröffentlichungstag der Anmeldung: 22.04.2015
(73) Patentinhaber: Valeo Schalter und Sensoren GmbH, 74321 Bietigheim-Bissingen (DE)
(72) Erfinder: INTINI, Onofrio, 71665 Vaihingen/Enz (DE)
(86) Internationale Anmeldenummer: PCT/EP2013/062153
(87) Internationale Veröffentlichungsnummer: WO 2013/186259

(56) Entgegenhaltungen:
- WO-A1-2008/131190
- WO-A1-2010/103221
- FR-A1- 2 346 180
- FR-A1- 2 880 145

## Beschreibung

Die Erfindung betrifft eine manuell bedienbare Schaltvorrichtung für ein Fahrzeug mit einem Schalthebel und zumindest einer an dem Schalthebel ausgebildeten berührsensitiven Sensorvorrichtung, die zur Erfassung eines den Schalthebel positionsunverändert lassenden und ein Schaltsignal auslösenden Einwirkens auf eine Sensorfläche der Sensorvorrichtung ausgebildet ist.

Eine derartige Schaltvorrichtung ist aus der DE 10 2009 022 471 A1 bekannt. Dort sind an einem Lenkstockschalter kapazitive Sensoren zur bewegungslosen Erfassung von Schaltvorgängen ausgebildet.

Aus der WO 2010/103221 A1 ist bereits eine gattungsgemäße Schaltvorrichtung mit einem Schalthebel und einer ersten berührsensitiven Sensorvorrichtung zur Erfassung eines den Schalthebel positionsunverändert lassenden und ein Schaltsignal auslösenden Einwirkens auf eine Sensorfläche bekannt. Eine zweite Sensorvorrichtung bildet eine Aktivierungseinrichtung, um den detektierenden Zustand der ersten Sensorvorrichtung nutzerdefiniert zu aktivieren.

Des Weiteren sind aus den Dokumenten FR 2 346 180 A1, WO 2008/131190 A1 und FR 2 880 145 A1 jeweils Lenkstockschalter mit berührungssensitiven Sensorvorrichtungen bekannt.

Es ist Aufgabe der vorliegenden Erfindung, eine manuell bedienbare Schaltvorrichtung für ein Fahrzeug so weiter zu bilden, dass unerwünschte Bedienungen vermieden werden können.

Diese Aufgabe wird durch eine Schaltvorrichtung gemäß dem unabhängigen Anspruch gelöst.

Eine erfindungsgemäße manuell bedienbare Schaltvorrichtung für ein Fahrzeug umfasst einen Schalthebel. Darüber hinaus umfasst die Schaltvorrichtung eine berührsensitive Sensorvorrichtung, welche an dem Schalthebel ausgebildet ist. Die Sensorvorrichtung ist zur Erfassung eines den Schalthebel positionsunverändert lassenden und ein Schaltsignal auslösenden Einwirkens auf eine Sensorfläche der Sensorvorrichtung ausgebildet. Es ist also vorgesehen, dass lediglich durch ein entsprechendes Einwirken, beispielsweise ein direktes Berühren oder ein in einem Erfassungsbereich der Sensorfläche Eindringen durch einen Gegenstand, beispielsweise durch einen Finger oder eine Hand eines Nutzers, ein Schaltsignal ausgelöst wird, ohne, dass dazu der Schalthebel in seiner Position verändert werden muss.

Ein wesentlicher Gedanke der Erfindung besteht darin, dass die Schaltvorrichtung eine Aktivierungseinrichtung aufweist, mit welcher der detektierende Zustand der Sensorvorrichtung nutzerdefiniert aktivierbar ist. Durch eine derartige Ausgestaltung der Schaltvorrichtung können unerwünschte Schaltsignalauslösungen und somit auch Fehlbedienungen vermieden werden. Die Sensorfläche ist somit nicht permanent im sensierenden und somit auch detektierenden Zustand, sondern muss, um diesen detektierenden Zustand aufzuweisen, zunächst erst entsprechend aktiviert werden. Dies wird gemäß der Erfindung durch den Nutzer selbst durchgeführt, so dass auch hier eine sehr bewusste und für den Nutzer intuitiv nachvollziehbare Vorgehensweise erforderlich ist. Dadurch wird auch eine hohe Sicherheit des Betriebs der Schaltvorrichtung ermöglicht. Erfindungsgemäß ist vorgesehen, dass die Aktivierungseinrichtung ein Bedienelement aufweist, welches an dem Schalthebel ausgebildet ist. Durch eine derartige Ausgestaltung kann eine sehr bauraumkompakte und im Hinblick auf das Aktivierungsszenario für einen Nutzer sehr leicht nachvollziehbar und intuitiv durchführbare Vorgehensweise ermöglicht werden.

Erfindungsgemäß ist vorgesehen, dass das Bedienelement außerhalb eines bei einem positionsverändernden Betätigen des Schalthebels für das Greifen durch einen Nutzer vorgesehenen Bereichs eines Endstücks des Schalthebels ausgebildet ist. Dabei ist besonders hervorzuheben, da somit das Bedienelement an einer spezifischen Position ausgebildet ist, die üblicherweise beim Greifen des Schalthebels zum Betätigen im Rahmen eines die Position des Schalthebels verändernden Einwirkens nicht direkt berührt oder kontaktiert wird, so dass auch in diesem Zusammenhang bei einem derartig spezifischen Einwirken auf den Schalthebel auch nicht unerwünscht automatisch der detektierende Zustand der Sensorfläche aktiviert wird.

Vorzugsweise ist vorgesehen, dass das Bedienelement und die Sensorfläche an gegenüberliegenden Rändern des Schalthebels angeordnet sind. Die oben genannten Vorteile werden dadurch nochmals bekräftigt.

Vorzugsweise ist vorgesehen, dass das Bedienelement an einem unteren Rand des Schalthebels ausgebildet ist. Dadurch wird die Betätigung des Bedienelements für einen Nutzer erleichtert.

Das Bedienelement kann ein manuell betätigbarer Drückschalter oder Kippschalter als beispielhafte Ausführung sein. Ebenso kann vorgesehen sein, dass auch das Bedienelement ein berührsensitiver Sensor ist.

Vorzugsweise ist vorgesehen, dass die Sensorfläche im aktivierten Zustand der Sensorvorrichtung und somit im detektierenden Zustand zumindest bereichsweise beleuchtet ist. Dadurch kann einem Nutzer auch sehr leicht wahrnehmbar dieser aktivierte Zustand angezeigt werden. Auch in der Nacht und bei einem somit unbeleuchteten bzw. abgedunkelten Fahrgastinnenraum, kann somit die Wahrnehmbarkeit des aktivierten Zustands sehr leicht erkannt werden.

Vorzugsweise ist vorgesehen, dass die Sensorfläche im aktivierten Zustand der Sensorvorrichtung in einer ersten Lichtfarbe beleuchtet ist und im deaktivierten Zustand der Sensorvorrichtung in einer zweiten Lichtfarbe beleuchtet ist. Die Wahrnehmbarkeit und Erkennbarkeit der jeweiligen Zustände werden dadurch nochmals verbessert.

Vorteilhaft ist es auch, wenn das Bedienelement beleuchtet ist. Dadurch kann die örtliche Position auch bei dunklen Lichtverhältnissen sehr leicht wahrgenommen werden und die Betätigung des Bedienelements sehr zielgerichtet und sicher durch einen Nutzer erfolgen.

Vorzugsweise ist vorgesehen, dass mit dem Betätigen der Aktivierungseinrichtung und einem somit Erzeugen des detektierenden Zustands der Sensorfläche dieser aktivierte Zustand für eine vorgegebene Zeitdauer bestehen bleibt und dann wiederum eine automatische Deaktivierung erfolgt. Dies ist insbesondere dann vorteilhaft, wenn in dieser Zeitdauer keine Berührung der Sensorfläche bzw. kein Einwirken auf die Sensorfläche dahingehend erfolgt, dass ein Schaltsignal ausgelöst werden würde.

Entsprechendes kann auch vorgesehen sein, wenn nach einem ein Schaltsignal auslösenden Einwirken auf die Sensorfläche für eine bestimmte vorgegebene Zeitdauer dann keine weitere Einwirkung auf die Sensorfläche erfolgt, so dass auch hier dann insbesondere automatisch wiederum der nicht-detektierende Zustand der Sensorfläche eingestellt wird.

Es kann jedoch auch vorgesehen sein, dass das Überführen der Sensorvorrichtung vom aktiven in den inaktiven Zustand ebenfalls nutzerdefiniert erfolgt, insbesondere durch ein wiederum entsprechendes Betätigen des Bedienelements.

In einer weiteren vorteilhaften Ausführung ist vorgesehen, dass die Schaltvorrichtung eine Vibrationseinrichtung aufweist, mit welcher bei einem ein Schaltsignal auslösenden Einwirkens auf die Sensorfläche der im aktivierten Zustand befindlichen Sensorvorrichtung ein Vibrationssignal als haptische Rückmeldung an den Nutzer erzeugbar ist, welches auf den Schalthebel einwirkt. Dies ist dahingehend besonders vorteilhaft, da dann auch der Nutzer unverzüglich Rückmeldung darüber erhält, ob seine Einwirkung auf die Sensorfläche auch zur gewünschten Schaltsignalauslösung und der damit verbundenen Einleitung einer Betriebsfunktion einer Funktionseinheit des Fahrzeugs geführt hat. Eine Vibrationseinrichtung ist in dem Zusammenhang dahingehend besonders vorteilhaft, da sie dem Nutzer eindeutig und leicht wahrnehmbar eine entsprechende Rückmeldung gibt und andererseits diesbezüglich keine unerwünschten und gegebenenfalls störenden bzw. nicht eindeutig zuordenbaren akustischen Signale oder optische Signale erzeugt werden. Diesbezüglich wird durch ein Vibrationssignal genau an der Stelle, nämlich am Schalthebel, eine Rückmeldung an den Nutzer gegeben, an dem auch die Betätigung durch den Nutzer erfolgt. Dies ist gerade in der modernen Fahrzeugtechnik dahingehend besonders vorteilhaft, da für weitere Funktionen und Einrichtungen ohnehin eine Vielzahl von gegebenenfalls akustischen und optischen Rückmeldungen gegeben werden und diesbezüglich dann durch das Vibrationssignal eine besonders leicht wahrnehmbare und dazu eindeutig abgegrenzte und zuzuordnende Rückmeldungsfunktion gegeben ist.

Vorzugsweise ist vorgesehen, dass die Vibrationseinrichtung einen Vibrationsmotor aufweist, der im Schalthebel angeordnet ist. Durch diese Ausgestaltung ist es ermöglicht, dass der Schalthebel auch als Aufnahme bzw. Träger für den Vibrationsmotor dient und insbesondere dabei zumindest bereichsweise hohl ausgebildet ist. Der Schalthebel kann auch in diesem Rahmen dann noch äußerst kompakt aufgebaut werden. Insbesondere kann damit jedoch auch die sehr direkte Übertragung des Vibrationssignals auf Teilbereiche des Schalthebels erfolgen, so dass auch hier eine unverzügliche und zuverlässige Rückmeldung an den Nutzer gegeben ist.

Vorzugsweise ist vorgesehen, dass der Vibrationsmotor durch Federarme oder ein Kabel an eine Steuereinheit auf einem Schaltungsträger kontaktiert ist, wobei insbesondere der Schaltungsträger in dem Schalthebel angeordnet ist.

Insbesondere kann auch vorgesehen sein, dass der Vibrationsmotor an einer flexiblen Leiterplatte, die zumindest einen kapazitiven Sensor der Sensorvorrichtung aufweist, angelötet ist.

Vorzugsweise ist vorgesehen, dass die Schaltvorrichtung ein Lenkstockschalter ist. Gerade derartige Lenkstockschalter sind in der modernen Fahrzeugtechnik mit einer Vielzahl von Betriebsfunktionen verknüpft, die abhängig von einem positionsverändernden Betätigen und/oder einem positionsunverändernden Betätigen ausgelöst werden können. Gerade bei Lenkstockschaltern ist es daher von besonderer Vorteilhaftigkeit, dass entsprechende spezifische Sensoren erst dann detektieren, wenn sie aktiviert sind, so dass hier gerade bei diesen Ausführungen unerwünschte Fehlbedienungen im besonderen Maße verhindert werden können. Dennoch bleibt die hohe Funktionalität mit der Auslösung einer Vielzahl von Betriebsfunktionen aufrechterhalten.

Weitere Merkmale der Erfindung ergeben sich aus den Ansprüchen, den Figuren und der Figurenbeschreibung. Die vorstehend in der Beschreibung genannten Merkmale und Merkmalskombinationen sowie die nachfolgend in der Figurenbeschreibung genannten und/oder in den Figuren alleine gezeigten Merkmale und Merkmalskombinationen sind nicht nur in der jeweils angegebenen Kombination, sondern auch in anderen Kombinationen oder in Alleinstellung verwendbar, ohne den Rahmen der Erfindung zu verlassen. Es sind somit auch Ausführungen von der Erfindung als umfasst und offenbart anzusehen, die in den Figuren nicht explizit gezeigt und erläutert sind, jedoch durch separierte Merkmalskombinationen aus den erläuterten Ausführungen hervorgehen und erzeugbar sind.

Ausführungsbeispiele der Erfindung werden nachfolgend anhand schematischer Zeichnungen näher erläutert. Es zeigen:
- Fig. 1: eine perspektivische Darstellung von Teilkomponenten eines Ausführungsbeispiels einer erfindungsgemäßen Schaltvorrichtung;
- Fig. 2: eine weitere perspektivische Darstellung der Ausgestaltung gemäß Fig. 1; und
- Fig. 3: eine teilweise Explosionsdarstellung der Schaltvorrichtung gemäß Fig. 1 und Fig. 2.

In den Figuren werden gleiche oder funktionsgleiche Elemente mit den gleichen Bezugszeichen versehen.

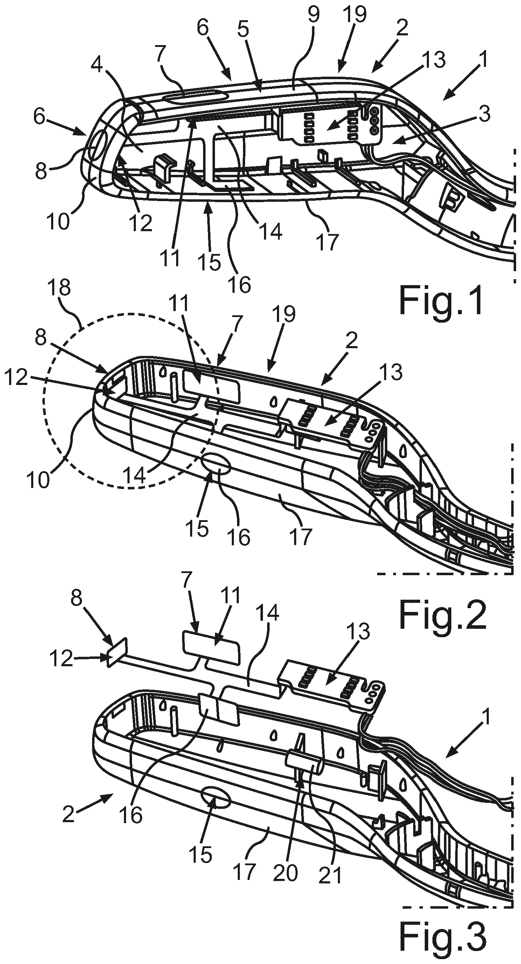

In Fig. 1 ist eine manuell bedienbare Schaltvorrichtung 1 vorgesehen, die in einem Fahrzeug angeordnet sein kann und als Lenkstockschalter 1 ausgebildet ist. Der Lenkstockschalter 1 kann beispielsweise im Bereich eines Lenkrads angeordnet sein, und umfasst einen Schalthebel 2. Der Schalthebel 2 ist im Ausführungsbeispiel länglich und gekrümmt ausgestaltet und ist hohl ausgestaltet. In einem Hohlraum 3, der durch eine Rückwand 4, eine in Fig. 1 nicht dargestellte und dadurch die Sicht in den Hohlraum 3 freigebende Vorderwand, und einen die Vorderwand und die Rückwand 4 verbindenden und umlaufenden Rand 5 begrenzt ist, sind eine Mehrzahl von Komponenten angeordnet.

An dem Schalthebel 2 ist darüber hinaus eine berührsensitive Sensorvorrichtung 6 ausgebildet. Die Sensorvorrichtung 6 ist zur Erfassung eines den Schalthebel 2 positionsunverändert lassenden und ein Schaltsignal auslösenden Einwirkens auf eine Sensorfläche der Sensorvorrichtung 6 ausgebildet. Im Ausführungsbeispiel sind zwei Sensorflächen 7 und 8 ausgebildet. Diese sind an unterschiedlichen Randbereichen des Rands 5 ausgestaltet, wobei dazu die Sensorfläche 7 an einem oberen Randbereich 9 ausgebildet ist, und die Sensorfläche 8 an einem seitlichen Randbereich 10 ausgebildet ist.

Insbesondere umfasst die Sensorvorrichtung 6 mit den Sensorflächen 7 und 8 gekoppelte kapazitive Sensoren 11 und 12.

Vorzugsweise ist vorgesehen, dass die kapazitiven Sensoren 11 und 12 durch eine leitende Kupferfläche auf einer Flexfolie gebildet sind. Insbesondere ist vorgesehen, dass diese Flexfolie an eine Steuereinheit 13 angeschlossen ist und eine direkte Interaktion mit einem aktivierenden Element, welches beispielsweise ein Finger eines Nutzers sein kann, darstellt. Die Sensorflächen 7 und 8 können mit der Außenhülle und somit dem Rand 5 des Schalthebels 2 verbunden sein, so dass sich diese direkt darunter unter der berührungssensitiven Fläche befindet.

Vorteilhaft ist es dabei, dass zwischen dem derartig ausgebildeten Sensor 11 bzw. 12 und der Außenhülle und somit dem Rand 5 kein Luftspalt gebildet ist. Dazu ist insbesondere vorgesehen, dass die kapazitiven Sensoren 11 und 12 jeweils auf einer Folie aufgebracht sind und diese Folie mit der Außenhülle und somit mit dem Rand 5 anhand beispielsweise eines Klebstoffs verbunden wird oder entsprechend umspritzt ist, so dass eine Integration der Folie in das Kunststoffmaterial des Rands 5 gegeben ist.

Vorzugsweise sind die kapazitiven Sensoren 11 und 12 mit einer flexiblen Leiterplatte 14 als Flexfolie verbunden, die wiederum direkt mit der Steuereinheit 13 verbunden ist. Die Steuereinheit 13 ist dabei auf einem Schaltungsträger aufgebracht, der ebenfalls flexibel sein kann oder als starre Platine ausgebildet ist.

Vorzugsweise ist vorgesehen, dass die Steuereinheit 13 bzw. die entsprechende Schaltung in unmittelbarer Nähe zu den Sensoren 11 und 12 angeordnet ist und somit in einem Nahbereich im Hohlraum 3 zu den Sensoren 11 und 12 positioniert ist. Durch eine derartig unmittelbare Nahpositionierung zwischen der Steuereinheit 13 und den Sensoren 11 und 12 kann die Eigenkapazität der Sensoren 11 und 12 im Bezug zur Masse sehr gering gehalten werden, da ansonsten längere Leiterbahnen ebenfalls mit der Umgebung interagieren und die Kapazität erhöhen. Es kann somit durch eine sehr kompakte und nahe Anordnung zueinander auch eine hohe Funktionssicherheit und Zuverlässigkeit erzielt werden.

Im Ausführungsbeispiel ist vorgesehen, dass Bedienfunktionen von Funktionseinheiten des Fahrzeugs durch Berühren einer Sensorfläche 7 oder 8 ausgelöst werden können oder allein durch das Nicht-Berühren, aber in einen Wirkbereich der Sensorfläche 7, 8 eintretenden Fingers oder dergleichen, ein Schaltsignal ausgelöst werden kann. Diese Betätigungen erfolgen somit derart, dass keine Positionsveränderung des Schalthebels 2 durchgeführt wird. Zusätzlich dazu kann vorgesehen sein, dass der Schalthebel 2 auch in seiner Position verändert werden kann, um entsprechende Schaltsignale für Bedienfunktionen von Funktionseinheiten auslösen zu können.

Im Hinblick auf derartige Funktionseinheiten können beispielsweise eine Lichteinheit, eine Scheibenwischervorrichtung, eine Scheibenwaschanlage, eine Lichthupe, ein Navigationssystem, ein Audiosystem oder ein Infotainement-System beispielhaft und vorgesehen sein.

Ein Einwirken auf die Sensorfläche 7 oder 8 ist somit durch ein direktes Berühren als auch durch ein Nicht-Berühren und Eindringen in einen Detektionsbereich möglich.

Um unerwünschte Fehleinstellungen und -betätigungen gerade der kapazitiven Sensoren 11 und 12 und somit eine unerwünschte Fehlbedienung bei einem die Position des Schalthebels 2 nicht verändernden Einwirken auf Sensorfläche 7 und 8 vermeiden zu können, umfasst die Schaltvorrichtung und somit der Lenkstockschalter 1 eine Aktivierungseinrichtung 15. Die Aktivierungseinrichtung 15 ist separat und beabstandet zu den kapazitiven Sensoren 11 und 12 und somit auch zu den Sensorflächen 7 und 8 am Schalthebel 2 ausgebildet. Die Aktivierungseinrichtung 15 umfasst ein Bedienelement 16, welches über einen unteren Randbereich 17 des Rands 5 nach außen hin zugänglich und betätigbar ist. Das Bedienelement 16 kann ein manuell betätigbarer Drückschalter oder Kippschalter oder dergleichen sein. Das Bedienelement 16 kann jedoch auch eine berührsensitive Bedienfläche sein.

Die kapazitiven Sensoren 11 und 12 sind gemäß einem Ausführungsbeispiel in ihrem Grundzustand deaktiviert, und es kann somit eine Detektion nicht stattfinden. Dies bedeutet, dass auch dann, wenn ein Einwirken auf die Sensorflächen 7 und 8 erfolgt, keine Detektion stattfindet und somit auch kein zugeordnetes Schaltsignal ausgelöst wird, so dass auch die dem Schaltsignal zugeordnete Bedienfunktion nicht eingeleitet bzw. ausgelöst wird.

Durch ein Betätigen des Bedienelements 16 werden die kapazitiven Sensoren 11 und 12 und somit auch die gesamte Sensorvorrichtung von einem deaktivierten in einen aktivierten Zustand übergeführt und die Sensorvorrichtung somit in den detektierenden Zustand geführt. Erst ab dann kann ein Einwirken auf die Sensorflächen 7 und 8 erkannt und erfasst werden und das entsprechende Schaltsignal ausgelöst werden. Das Bedienelement 16 ist ebenfalls mit der flexiblen Leiterplatte 14 elektrisch verbunden und über diese mit der Steuereinheit 13 gekoppelt.

Mit der Aktivierungseinrichtung 15 wird somit der detektierende Zustand der Sensorvorrichtung 6 nutzerdefiniert aktiviert.

Es kann vorgesehen sein, dass der aktivierte Zustand der Sensorvorrichtung 6 auch nutzerdefiniert, insbesondere durch Betätigen des Bedienelements 16, wieder deaktiviert wird. Es kann jedoch auch vorgesehen sein, dass der deaktivierte Zustand automatisch nach einer vorgegebenen Zeitdauer nach dem Einstellen des aktivierten Zustands wieder automatisch eingestellt wird.

Insbesondere ist auch vorgesehen, dass die Sensorflächen 7 und 8 zumindest bereichsweise beleuchtet sind. Beispielsweise können hier Leuchtdioden vorgesehen sein, die im Hohlraum 3 angeordnet sind. Es kann dazu vorzugsweise vorgesehen sein, dass die Sensorflächen 7 und 8 in einem aktivierten Zustand der Sensorvorrichtung 6 in einer ersten Lichtfarbe beleuchtet sind, und im deaktivierten Zustand der Sensorvorrichtung 6 in einer zweiten Lichtfarbe beleuchtet sind.

Vorzugsweise ist auch vorgesehen, dass das Bedienelement 16 zumindest bereichsweise beleuchtet ist.

Durch die Aktivierungseinrichtung 15 ist sichergestellt, dass während der Betätigung einer Basisschalterfunktion, die beispielsweise ein Blinken, eine Lichthupe, ein Fernlicht oder eine Scheibenwaschen sein kann, keine Hebelfunktion durch Berühren der sensitiven Flächen bzw. der Sensorflächen 7 und 8 ungewollt aktiviert wird.

Es ist gemäß der Darstellung in Fig. 1 und Fig. 2 auch zu erkennen, dass das Bedienelement 16 außerhalb eines für das Greifen durch einen Nutzer vorgesehenen Bereichs 18 eines Endstücks 19 des Schalthebels 2 ausgebildet ist. Dieser Bereich 18 ist insbesondere dann erforderlich und vorgesehen, wenn der Schalthebel 2 zum Auslösen eines Schaltsignals für eine spezifische Betriebsfunktion in seiner Position verändert werden muss und dadurch durch einen Nutzer entsprechend gegriffen werden muss. Für eine derartige spezifische Positionierung des Bedienelements 16 kann beim Greifen dieses Bereichs 18 durch einen Nutzer ein ungewolltes Betätigen des Bedienelements 16 verhindert werden.

Im Hinblick auf die Visualisierung der aktivierten Sensorflächen 7 und 8 kann beispielsweise ein Lichtfarbwechsel von rot auf grün erfolgen und die grüne Lichtfarbe dann leuchten, wenn der aktivierte Zustand der Sensorvorrichtung 6 gegeben ist. Ebenso können jedoch auch beleuchtete Symbole vorgesehen sein, die ebenfalls über einen Lichtfarbwechsel dem Fahrzeugführer die Bereitschaft signalisieren und somit den aktivierten Zustand anzeigen.

Besonders vorteilhaft ist es auch, dass die Ausgestaltung des Lenkstockschalters 1 eine Vibrationseinrichtung 20 (Fig. 3) aufweist, welche ebenfalls in dem Hohlraum 3 angeordnet ist. In Fig. 3 ist dazu eine teilweise Explosionsdarstellung des Lenkstockschalters 1 gezeigt. Es ist dabei zu erkennen, dass ein Vibrationsmotor 21 der Vibrationseinrichtung 20 unter dem Schaltungsträger der Steuereinheit 13 angeordnet ist. Er ist somit unmittelbar benachbart zu diesem Schaltungsträger angeordnet und kann mit diesem entsprechend verbunden sein. Durch die Vibrationseinrichtung 20 wird dem Nutzer ein haptisches Feedback in Form eines Vibrationssignals gegeben, um die Betätigung und das Einwirken auf die Sensorflächen 7 und 8 bestätigen zu können. Das Vibrationssignal wird dabei über den Vibrationsmotor 21 auf den Schalthebel 2 übertragen, so dass ein unmittelbares und eindeutiges Rückmelden an einen Nutzer gegeben ist.

Es kann vorgesehen sein, dass der Vibrationsmotor 21 durch Federarme oder ein Kabel an die Steuereinheit 13 auf dem Schaltungsträger kontaktiert ist. Es kann auch vorgesehen sein, dass der Vibrationsmotor 21 an einer flexiblen Leiterplatte, insbesondere der Leiterplatte 14 angelötet ist. Insbesondere kann der Vibrationsmotor 21 auch über das Kabel an den Schaltungsträger der Steuereinheit 13 angelötet sein.

## Patentansprüche

1. Manuell bedienbare Schaltvorrichtung (1) für ein Fahrzeug, mit einem Schalthebel (2) und zumindest einer an dem Schalthebel (2) ausgebildeten berührsensitiven Sensorvorrichtung (6), die zur Erfassung eines den Schalthebel (2) positionsunverändert lassenden und ein Schaltsignal auslösenden Einwirkens auf eine Sensorfläche (7, 8) der Sensorvorrichtung (6) ausgebildet ist,
wobei eine Aktivierungseinrichtung (15) ausgebildet ist, mit welcher der
detektierende Zustand der Sensorvorrichtung (6) nutzerdefiniert aktivierbar ist, wobei die Aktivierungseinrichtung (15) ein Bedienelement (16) aufweist, welches an dem Schalthebel (2) ausgebildet ist,
**dadurch gekennzeichnet, dass** das Bedienelement (16) außerhalb eines bei einem positionsverändernden Betätigen des Schalthebels (2) für das Greifen durch einen Nutzer vorgesehenen Bereichs (18) eines Endstücks (19) des Schalthebels (2) ausgebildet ist.

2. Schaltvorrichtung (1) nach Anspruch 1,
**dadurch gekennzeichnet, dass**
das Bedienelement (16) und die Sensorfläche (7, 8) an gegenüberliegenden Randbereichen (9, 10, 17) eines Rands (5) des Schalthebels (2) angeordnet sind.

3. Schaltvorrichtung (1) nach Anspruch 2,
**dadurch gekennzeichnet, dass**
das Bedienelement (16) an einem unteren Randbereich (17) des Schalthebels (2) ausgebildet ist.

4. Schaltvorrichtung (1) nach einem der vorhergehenden Ansprüche,
**dadurch gekennzeichnet, dass**
die Sensorfläche (7, 8) im aktivierten Zustand der Sensorvorrichtung (6) zumindest bereichsweise beleuchtet ist.

5. Schaltvorrichtung (1) nach Anspruch 4,
**dadurch gekennzeichnet, dass**
die Sensorfläche (7, 8) im aktivierten Zustand der Sensorvorrichtung (6) in einer ersten Lichtfarbe beleuchtet ist und im deaktivierten Zustand der Sensorvorrichtung (6) in einer zweiten Lichtfarbe beleuchtet ist.

6. Schaltvorrichtung (1) nach einem der vorhergehenden Ansprüche,
**dadurch gekennzeichnet, dass**
eine Vibrationseinrichtung (20) ausgebildet ist, mit welcher bei einem ein Schaltsignal auslösenden Einwirken auf die Sensorfläche (7, 8) der im aktivierten Zustand befindlichen Sensorvorrichtung (6) ein Vibrationssignal als haptische Rückmeldung an den Nutzer erzeugbar ist.

7. Schaltvorrichtung (1) nach Anspruch 6,
**dadurch gekennzeichnet, dass**
die Vibrationseinrichtung (20) einen Vibrationsmotor (21) aufweist, der im Schalthebel (2) angeordnet ist.

8. Schaltvorrichtung (1) nach Anspruch 7,
**dadurch gekennzeichnet, dass**
der Vibrationsmotor (21) durch Federarme oder ein Kabel an eine Steuereinheit (13) auf einem Schaltungsträger kontaktiert ist.

9. Schaltvorrichtung (1) nach Anspruch 7 oder 8,
**dadurch gekennzeichnet, dass**
der Vibrationsmotor (21) an einer flexiblen Leiterplatte (14), die zumindest einen kapazitiven Sensor (11, 12) der Sensorvorrichtung (6) aufweist, angelötet ist.

10. Schaltvorrichtung nach einem der vorhergehenden Ansprüche,
**dadurch gekennzeichnet, dass**
sie ein Lenkstockschalter (1) ist.

## Claims

1. Manually operated switching device (1) for a vehicle, with a switch lever (2) and at least one touch-sensitive sensor device (6) formed on the switch lever (2), which is designed for detecting an effect on a sensor surface (7, 8) of the sensor device (6) that leaves the switch lever (2) positionally unchanged and that triggers a switching signal, wherein an activation device (15) is formed, with which the detecting state of the sensor device (6) can be activated as defined by the user, wherein the activation device (15) comprises an operating element (16), which is formed on the switch lever (2),
**characterized in that** the operating element (16) is formed outside a region (18) of an end piece (19) of the switch lever (2) that is provided for gripping by a user in the case of a position-changing operation of the switch lever (2).

2. Switching device (1) according to Claim 1,
**characterized in that**
the operating element (16) and the sensor surface (7, 8) are disposed on opposite edge regions (9, 10, 17) of an edge (5) of the switch lever (2).

3. Switching device (1) according to Claim 2,
**characterized in that**
the operating element (16) is formed on a lower edge region (17) of the switch lever (2).

4. Switching device (1) according to any one of the preceding claims, **characterized in that**
the sensor surface (7, 8) is illuminated at least in some regions in the activated state of the sensor device (6).

5. Switching device (1) according to Claim 4,
**characterized in that**
the sensor surface (7, 8) is illuminated in a first light colour in the activated state of the sensor device (6) and is illuminated in a second light colour in the deactivated state of the sensor device (6).

6. Switching device (1) according to any one of the preceding claims,
**characterized in that**
a vibration device (20) is formed, with which a vibration signal can be generated as haptic feedback to the user in the case of an effect on the sensor surface (7, 8) of the sensor device (6) in the activated state that triggers a switching signal.

7. Switching device (1) according to Claim 6,
**characterized in that**
the vibration device (20) comprises a vibration motor (21), which is disposed in the switch lever (2).

8. Switching device (1) according to Claim 7,
**characterized in that**
the vibration motor (21) is contacted by spring arms or a cable on a control unit (13) on a circuit board.

9. Switching device (1) according to Claim 7 or 8,
**characterized in that**
the vibration motor (21) is soldered to a flexible circuit board (14), which comprises at least one capacitive sensor (11, 12) of the sensor device (6).

10. Switching device according to any one of the preceding claims,
**characterized in that** it is a steering column switch (1).

## Revendications

1. Dispositif de commutation (1) à actionnement manuel pour un véhicule, avec un levier de commutation (2) et au moins un dispositif de détection (6) tactile réalisé au niveau du levier de commutation (2) et réalisé de façon à détecter une action laissant le levier de commutation (2) sans changement de position et déclenchant un signal de commutation sur une surface de détection (7, 8) du dispositif de détection (6), un dispositif d'activation (15) étant réalisé à l'aide duquel l'état détecté du dispositif de détection (6) peut être activé de façon définie par l'utilisateur, le dispositif d'activation (15) comportant un élément de commande (16) réalisé au niveau du levier de commutation (2), **caractérisé en ce que** l'élément de commande (16) est réalisé en dehors d'une plage (18) d'une pièce d'extrémité (19) du levier de commutation (2) prévue, en cas d'actionnement à variation de position du levier de commutation (2), pour être prise par un utilisateur.

2. Dispositif de commutation (1) selon la revendication 1, **caractérisé en ce que** l'élément de commande (16) et la surface de détection (7, 8) sont disposés au niveau de régions de bordure (9, 10, 17) opposées d'une bordure (5) du levier de commutation (2).

3. Dispositif de commutation (1) selon la revendication 2, **caractérisé en ce que** l'élément de commande (16) est réalisé au niveau d'une région de bordure (17) inférieure du levier de commutation (2).

4. Dispositif de commutation (1) selon l'une quelconque des revendications précédentes, **caractérisé en ce que** la surface de détection (7, 8) est éclairée au moins partiellement dans l'état activé du dispositif de détection (6).

5. Dispositif de commutation (1) selon la revendication 4, **caractérisé en ce que** la surface de détection (7, 8) est éclairée dans une première couleur lumineuse dans l'état activé du dispositif de détection (6) et est éclairée dans une deuxième couleur lumineuse dans l'état désactivé du dispositif de détection (6).

6. Dispositif de commutation (1) selon l'une quelconque des revendications précédentes, **caractérisé en ce qu'**un dispositif vibrant (20) est réalisé à l'aide duquel en cas d'action de déclenchement d'un signal de commutation sur la surface de détection (7, 8), un signal vibrant servant de retour haptique à l'utilisateur peut être produit par le dispositif de détection (6) se trouvant dans l'état activé.

7. Dispositif de commutation (1) selon la revendication 6, **caractérisé en ce que** le dispositif vibrant (20) comporte un moteur à vibration (21) disposé dans le levier de commutation (2).

8. Dispositif de commutation (1) selon la revendication 7, **caractérisé en ce que** le moteur à vibration (21) est mis en contact par des bras sur ressort ou un câble au niveau d'une unité de commande (13) prévue sur un support de circuit.

9. Dispositif de commutation (1) selon la revendication 7 ou 8, **caractérisé en ce que** le moteur à vibration (21) est brasé à une plaque conductrice (14) flexible comportant au moins un capteur (11, 12) capacitif du dispositif de détection (6).

10. Dispositif de commutation selon l'une quelconque des revendications précédentes, **caractérisé en ce qu'**il est un contacteur commodo (1).
